# EUROPEAN PATENT APPLICATION

(11) **EP 2 103 698 A1**
(43) Date of publication of application: **23.09.2009**
(21) Application number: 09155099.6
(22) Date of filing: 13.03.2009
(51) Int. Cl.: C22C 5/02, C23C 14/18, C23C 14/34, A44C 27/00

(54) **Method of manufacturing a decorative article, a decorative article, and a timepiece**

(30) Priority: 17.03.2008 JP 2008068517
(71) Applicant: Seiko Epson Corporation, Shinjuku-ku Tokyo 163-0811 (JP)
(72) Inventor: Kawakami, Atsushi, Nagano 392-8502 (JP); Obi, Yoshiyuki, Nagano 392-8502 (JP)
(74) Representative: HOFFMANN EITLE

(57) **Abstract**

A method of manufacturing a decorative article, including a first coating formation step of forming a first coating of primarily TiN on a base member, and a second coating formation step of forming a second coating on the first coating by means of a dry plating method using an Au-Pd-Ag-In alloy of primarily Au and containing 6.0 - 9.0 wt% Pd, 6.0 - 8.0 wt% Ag, and 7.0 - 9.0 wt% In as a target.

## Description

### BACKGROUND

### 1. Field of Invention

The present invention relates to a method of manufacturing a decorative article, to a decorative article, and to a timepiece.

### 2. Description of Related Art

An attractive, aesthetically appealing appearance is needed in decorative articles such as used for the case member of a timepiece. This has generally been achieved by using a metal such as Pt or Ag to make the decorative parts.

The hardness of such metals is, however, generally relatively low, and decorative articles (particularly external parts for timepieces and accessories) made of such metals are subject to easy surface scratching, resulting in a dramatic drop in appearance over long-term use.

In order to solve this problem, Japanese Unexamined Patent Appl. Pub. JP-A-H11-229114 teaches technology for hardening the surface by a carburization process that injects carbon into a stainless steel base member as a technology for hardening the base member.

However, carburization causes surface roughening and thus changes the polished appearance. Mirror-finished articles in particular become rough and cloudy, and thus cannot be used as is as a decorative article.

As a result, carburization is generally followed by a mechanical polishing process as a method of rendering a mirror finish. With this method, however, mechanical polishing grinds away the hardened layer and hardness therefore drops. A further disadvantage is that shapes that cannot be polished (forms that cannot be reached with the buffing wheel) cannot be processed.

Furthermore, because the colors that can be rendered in base members that have been carburized as described above lack a sense of high quality, it is difficult to use base members that have been so treated in decorative articles that require an outstanding appearance (particularly articles requiring a pale gold color).

Decorative articles with the desired pale gold tone can be achieved by forming an Au-Ni layer by means of dry plating. The color of the Au-Ni layer formed in such decorative articles tends to change easily over time, and it is not possible to retain an outstanding appearance over the long term.

In addition, Ni has been shown to have adverse effects on the body (particularly allergic reactions), and its use in decorative articles is increasingly discouraged. SUMMARY

A decorative article according to the present invention retains outstanding hardness and and an excellent appearance for a long time. Another aspect of the invention is a method of manufacturing this decorative article. Yet another aspect of the invention is a timepiece incorporating this decorative article.

A first aspect of the invention is a method of manufacturing a decorative article, including a first coating formation step of forming a first coating of primarily TiN on a base member; and a second coating formation step of forming a second coating on the first coating by means of a dry plating method using an Au-Pd-Ag-In alloy of primarily Au and containing 6.0 - 9.0 wt% Pd, 6.0 - 8.0 wt% Ag, and 7.0 - 9.0 wt% In as a target.

This manufacturing method enables producing a decorative article that retains outstanding hardness and a beautiful appearance for a long time.

Preferably, the second coating is formed by sputtering.

This enables consistently manufacturing decorative articles with a particularly outstanding appearance.

Further preferably, the method of manufacturing a decorative article also has a base layer formation step of forming a base layer of at least one layer on the base member before the first coating formation step.

This method can improve adhesion between the base member and first coating, for example, and render a decorative article with particularly outstanding reliability and durability.

Yet further preferably, a layer of primarily Ti is formed as the base layer.

This further improves adhesion between the base member and first coating, and can render a decorative article with particularly outstanding reliability and durability.

A decorative article according to another aspect of the invention is manufactured using the method of the invention.

As a result, the decorative article can retain outstanding hardness and a beautiful appearance for a long time.

A decorative article according to another aspect of the invention has a base member; a first coating of primarily TiN; and a second coating that is disposed on the opposite surface of the first coating as the surface facing the base member, and is formed from an Au-Pd-Ag-In alloy of primarily Au and containing 6.0 - 9.0 wt% Pd, 6.0 - 8.0 wt% Ag, and 7.0 - 9.0 wt% In.

As a result, the decorative article can retain outstanding hardness and a beautiful appearance for a long time.

In a decorative article according to another aspect of the invention the base member is made of primarily Ti and/or stainless steel at least in the surface region.

This enables providing the decorative article with particularly outstanding hardness, excellent resistance to scratching and denting, and the ability to retain an outstanding appearance for a long time. Adhesion between the base member and first coating is also particularly outstanding.

In a decorative article according to another aspect of the invention the N content in the first coating is preferably 2 - 29 wt%.

This provides the decorative article with a particularly outstanding appearance and the ability to retain an outstanding appearance for a long time.

Further preferably, the average thickness of the first coating is 0.1 - 5.0 µm.

This effectively prevents an increase in internal stress in the first coating, renders the decorative article particularly resistant to scratching and denting, and enables retaining an outstanding appearance for a long time.

Further preferably, the average thickness of the second coating is 0.02 - 2.0 µm.

This renders the decorative article with a particularly outstanding appearance while maintaining sufficiently high hardness and an outstanding appearance for a longer time.

In a decorative article according to another aspect of the invention the color tone of the surface on the side to which the second coating is disposed has an a* in the range 0.7 - 2.9 and a b* in the range 12.3 - 16.9 when expressed in the L*a*b* chromaticity diagram defined in JIS Z 8729.

This renders the appearance of the decorative article particularly outstanding.

Further preferably, the color tone of the surface of the decorative article on the side to which the second coating is disposed has an L* in the range 84.2 - 88.4 when expressed in the L*a*b* chromaticity diagram defined in JIS Z 8729.

This renders the appearance of the decorative article particularly outstanding.

Decorative article according to the invention is preferably an external part of a timepiece.

The external parts of a timepiece are generally decorative articles that are easily subject to external impact, and require both a beautiful appearance as decorative parts and durability as utilitarian parts. The invention enables satisfying both of these requirements.

A timepiece according to the invention incorporates the decorative article of the invention.

This enables providing a timepiece that can retain an outstanding appearance for a long time.

The invention can thus provide decorative articles that can retain outstanding hardness and an attractive appearance for a long time, a method of manufacturing these decorative articles, and a timepiece that uses the decorative articles.

Other objects and attainments together with a fuller understanding of the invention will become apparent and appreciated by referring to the following description and claims taken in conjunction with the accompanying drawings.

### BRIEF DESCRIPTION OF THE DRAWINGS

FIG. 1 is a section view of a decorative article according to a first embodiment of the invention.

FIG. 2 is a section view describing a preferred embodiment of a method of manufacturing the decorative article shown in FIG. 1.

FIG. 3 is a section view of a decorative article according to a second embodiment of the invention.

FIG. 4 is a section view describing a preferred embodiment of a method of manufacturing the decorative article shown in FIG. 3.

FIG. 5 is a partial section view showing a preferred embodiment of a timepiece (a portable timepiece) according to the present invention.

### DESCRIPTION OF PREFERRED EMBODIMENTS

Preferred embodiments of the present invention are described below with reference to the accompanying figures.

A first embodiment of a decorative article and a preferred embodiment of a method of manufacturing the decorative article according to the present invention are described first below.

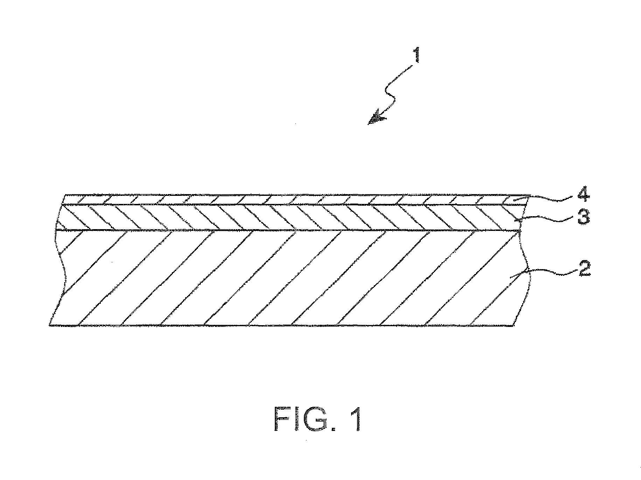

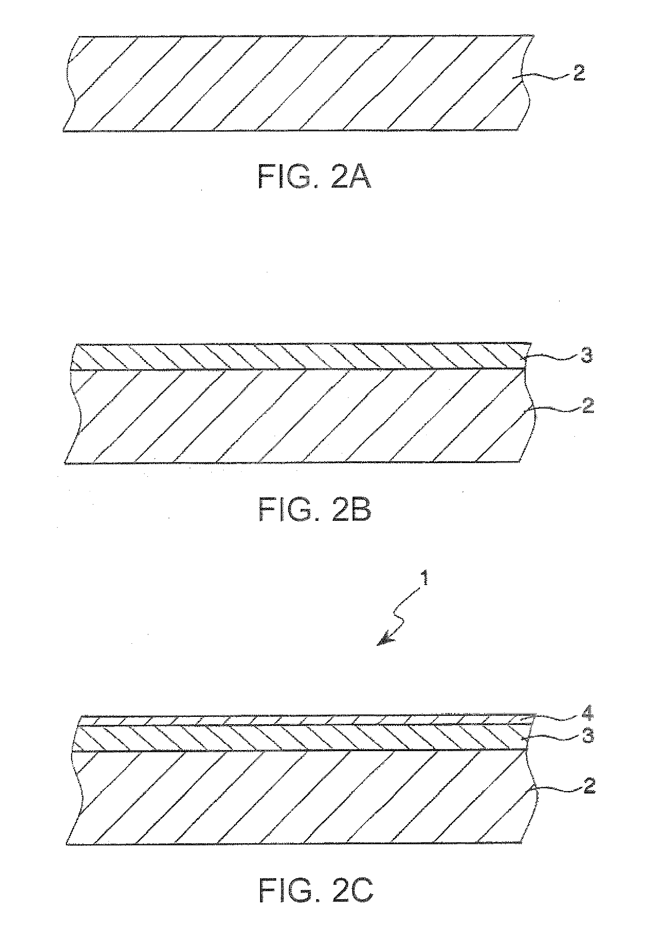

FIG. 1 is a section view of a decorative article according to a first embodiment of the invention, and FIG. 2 is a section view describing a preferred embodiment of a method of manufacturing the decorative article shown in FIG. 1.

As shown in FIG. 1, a decorative article 1 according to this embodiment of the invention has a base member 2, a first coating 3, and a second coating 4.

* Base member

The base member 2 can be made of any desired material, including metallic and non-metallic materials.

When the base member 2 is metal a decorative article 1 with an excellent strength characteristic can be provided.

If the base member 2 is made of metal and the surface roughness of the base member 2 is relatively high, the levelling effect of forming the first coating 3 and second coating 4 described below can reduce the surface roughness of the resulting decorative article 1. For example, even if mechanical processing such as grinding or polishing the surface of base member 2 is not used, a mirror finish can still be achieved. A mirror surface can even be easily achieved when the base member 2 is formed using a metal injection molding (MIM) method and the surface has a satin finish. A decorative article with excellent luster can thus be achieved.

If the base member 2 is a non-metallic material, a decorative article 1 that is relatively light and portable and has a substantial appearance can be provided.

When the base member 2 is a non-metallic material it can also be processed relatively easily to a desired shape. This makes it possible to manufacture relatively easily a decorative article 1 with a shape that is difficult to mold directly.

Furthermore, an electromagnetic noise shielding effect can also be achieved when the base member 2 is a non-metallic material.

Metal materials that can be used for the base member 2 include metals such as Fe, Cu, Zn, Ni, Mg, Cr, Mn, Mo, Nb, Al, V, Zr, Sn, Au, Pd, Pt, and Ag, and alloys (such as stainless steel or brass) containing at least one of these.

If at least the surface portion of the base member 2 is made primarily from Ti and/or stainless steel, the decorative article 1 will have particularly outstanding hardness, and will be particularly resistant to surface damage such as scratching, marring, and denting. As a result, the decorative article 1 will be able to retain an outstanding appearance for a longer time. Furthermore, if at least the surface portion of the base member 2 is made primarily from Ti and/or stainless steel (and particularly if primarily Ti), the decorative article 1 will have particularly outstanding adhesion with the first coating 3 described below.

Note that as used herein "primarily" indicates the component with the highest content ratio in the materials constituting the obj ect part (member), and while the specific content is not specifically defined, it is preferably 70 wt% or more of the materials in the object part (member), further preferably 90 wt% or more, and yet further preferably 95 wt% or more.

Examples of materials of primarily Ti include Ti (solid Ti) and Ti alloys. Exemplary stainless steel materials include Fe-Cr alloys and Ce-Cr-Ni alloys. Examples of Fe-Cr-Ni alloys include SUS 304, SUS 303, SUS 316, SUS 316L, SUS 316J1, AND SUS 316J1L. Examples of Fe-Cr alloys include SUS 405, SUS 430, SUS 434, SUS 444, SUS 429, and SUS 430F.

If the base member 2 is a non-metallic material it could be plastic, ceramic, stone, wood, or glass, for example.

Exemplary plastic materials include thermoplastic resins and thermosetting resins, such as polyethylene, polypropylene, ethylene-propylene copolymer, ethylene-vinyl acetate copolymer (EVA) and other polyolefins, cyclic polyolefins, denatured polyolefins, polyvinyl chloride, polyvinylidene chloride, polystyrene, polyamide (such as nylon 6, nylon 46, nylon 66, nylon 610, nylon 612, nylon 11, nylon 12, nylon 6-12, nylon 6-66), polyimide, polyamide-imide, polycarbonate (PC), poly-(4-methylbetene-1), ionomer, acrylic resins, polymethylmethacrylate, acrylonitrile-butadiene-styrene copolymer (ABS resin), acrylonitrile-styrene copolymer (AS resin), butadiene-styrene copolymer, polyoxymethylene, polyvinyl alcohol (PVA), ethylene vinyl alcohol copolymer (EVOH), polyethylene terephthalate (PET), polybutylene terephthalate (PBT), polycyclohexane terephthalate (PCT) and other polyesters, polyether, polyether ketone (PEK), polyether ether ketone (PEEK), polyether imide, polyacetal (POM), polyphenylene oxide, denatured polyphenylene oxide, polysulfone, polyethersulfone, polyphenylene sulfide, polyarylate, aromatic polyester (liquid crystal polymer), polytetratluoroethylene, polyvinylidene fluoride, and other fluororesins, styrenes, polyolefins, polyvinyl chlorides, polyurethanes, polyesters, polyamides, polybutadienes, transpolyisoprenes, fluoroelastomers, polyethylene chlorides and other thermoplastic elastomers, epoxy resin, phenol resin, urea resin, melamine resin, unsaturated polyester, silicon resin, urethane resin, poly-para-xylylene, poly-monochloro-para-xylyiene, poly-dichloro-para-xylylene, poly-monofluoro-para-xylylene, poly-monoethyl-para-xylylene, and other poly-para-xylylene resins, as well as copolymers, blends, and polymer alloys of primarily the foregoing, and one or two or more of the foregoing used together (as blended resins, polymer alloys, or laminates, for example).

If the base member 2 is plastic, a decorative article 1 that is relatively light and portable while having a substantial appearance can be achieved.

A plastic base member 2 can also be molded relatively easily to a desired shape. This makes it possible to manufacture relatively easily a decorative article 1 with a complicated shape.

Furthermore, an electromagnetic noise shielding effect can also be achieved when the base member 2 is made of plastic.

Exemplary ceramic materials include, for example, oxide ceramics such as Al₂O₃, SiO₂, TiO₂, ZrO₂, Y₂O₃, barium titanate, and strontium titanate; nitride ceramics such as AlN, Si₃N₄, SiN, TiN, BN, ZrN, HfN, VN, TaN, NbN, CrN, and Cr₂N; graphite and carbide ceramics such as SiC, ZrC, Al₄C₃, CaC₂, WC, TiC, HfC, VC, TaC, and NbC; boride ceramics such as ZrB₂ and MoB; and compound ceramics combining any two or more such ceramics.

When the base member 2 is made from such a ceramic, a decorative article 1 with high strength and high hardness can be achieved.

The composition of the base member 2 may be effectively uniform in each part thereof, or the composition may differ according to the location. For example, the base member 2 may have a base layer and a surface layer disposed over the base layer. If the base member 2 is thus rendered, greater freedom molding the base member 2 can be achieved by appropriately selecting the material of the base layer, and even decorative articles 1 with relatively complicated shapes can be manufactured relatively easily.

If the base member 2 has a base layer and a surface layer made of metal, the (average) thickness of the surface layer is not specifically limited but is preferably 0.1 - 50 µm, and is further preferably 1.0 - 10 µm. If the thickness of the surface layer is within this range, the base member 2 can be rendered with sufficiently high hardness while also more reliably preventing unintended separation of the surface layer from the base layer.

In addition, the shape and size of the base member 2 are not specifically limited, and are usually determined based on the shape and size of the decorative article 1.

* First coating

A first coating 3 is disposed on the surface of the base member 2. This first coating 3 is made of primarily TiN.

Disposing this first coating 3 renders the entire decorative article 1 with particularly outstanding hardness (on the side on which the first coating 3 and second coating 4 are disposed), and renders the decorative article 1 resistant to surface damage such as scratching, marring, and denting. In addition, disposing this first coating 3 renders the decorative article 1 overall with a particularly outstanding appearance even when the thickness of the second coating 4 described below is relatively low.

More specifically, the effect of the color of the first coating 3 on the aesthetic appearance of the decorative article 1 increases when the thickness of the second coating 4 described below is relatively thin, but because the color (chromaticity) of TiN (the first coating 3) and the color (chromaticity) of the second coating 4 are relatively similar (the difference is small), a decorative article 1 with an overall outstanding aesthetic appearance can be achieved even when the second coating 4 is relatively thin.

In addition, if for example, the second coating 4 becomes worn or peels during long-term use of the decorative article 1, the adverse effect on the aesthetic appearance of the decorative article 1 can be minimized.

On the other hand, if the decorative article does not have a first coating of TiN, the decorative article cannot be imparted with sufficiently high hardness overall. As a result, the decorative article will be easily subject to surface damage such as scratching, marring, and denting. In addition, if the decorative article does not have a first coating of TiN, the effect of the color of the base member on the appearance of the decorative article will increase. In this case, the appearance of the decorative article may be dramatically impaired depending upon the thickness and other aspects of the second coating.

The content of N (X_{1N}) in the first coating 3 is not specifically limited but is preferably 2.0 - 29.0 wt%, further preferably 5.0 -27.0 wt% and yet further preferably 7.0 - 24.0 wt%, and most preferably 8.0 - 16.0 wt%. If the content of N in the first coating 3 is a value within the foregoing range, the hardness of the decorative article 1 is rendered sufficiently high and the color (chromaticity) of the first coating 3 can be optimized. As a result, the effect of the present invention is particularly dramatic.

However, if the content of N in the first coating 3 is less than the lower limit of the foregoing range, it is difficult, depending upon the thickness of the first coating 3 and the composition of the second coating 4, to render the hardness of the decorative article 1 sufficiently high.

Furthermore, if the content of N in the first caating 3 exceeds the upper limit of the foregoing range, the color tone of the first coating 3 becomes too deep (too goldish) and can adversely affect the appearance of the decorative article 1 depending upon, for example, the thickness of the second coating 4.

The first coating 3 may contain components (constituent elements) other than Ti and N. For example, the first coating 3 may contain a predetermined amount of C (carbon). This helps reduce the difference between the tone of the first coating 3 and the tone of the second coating 4 described below, and further increases the hardness of the first coating 3. As a resuit, this makes the effect of the present invention even more dramatic.

If the first coating 3 is rendered from a material (TiCN) containing C, the sum (X₁) of the content (X_{1C}) of C and the content of N (X_{1N}) in the first coating 3 is not specifically limited but is preferably 5 - 30 wt%, further preferably 10.0 - 28.0 wt%, and yet further preferably 15 - 25.0 wt%.

The content of C (X_{1C}) in the first coating 3 is preferably 0.5 - 12.0 wt%, further preferably 1.0 - 10.0 wt%, and yet further preferably 5.0 - 9.0 wt%.

If the content of C in the first coating 3 is a value within the foregoing range, the hardness of the Decorative article 1 is rendered sufficiently high and the color (chromaticity) of the first coating 3 can be optimized. As a result, the effect of the present invention is particularly dramatic.

However, if the content of C in the first coating 3 exceeds the upper limit of the foregoing range, the color tone of the first coating 3 becomes too deep (too blackish) and can adversely affect the appearance of the decorative article 1 depending upon, for example, the thickness of the second coating 4.

Furthermore, the content X_{1C} (wt%) of C in the first coating 3 is preferably lower than the content X_{1N} (wt%) of N in the first coating 3. This can effectively prevent the tone of the first coating 3 from becoming too black, and as a result (particularly when the thickness of the second coating 4 is relatively thin) can render the appearance of the decorative article 1 particularly outstanding.

When the first coating 3 contains a predetermined amount of C (such as when it is made of TiCN as described above), the decorative article 1 has sufficient stability under normal conditions of use (such as a temperature of -50 - 120°C and relative humidity of C - 100%) while the 3 can be easily and reliably removed without actually damaging the base member 2 by using a specific chemical. Therefore, if the first coating 3 of the decorative article 1 becomes soiled or contaminated, for example, the first coating 3 can be removed and a new first coating 3 can be applied. Because the coating (first coating) can be removed using a specific chemical and then recoated easily and reliably, its characteristics can be enjoyed for a very long time.

Stripping agents that can be used to remove the first coating 3 include, for example, solvents such as nitric acid (HNO₃) and sulfuric acid (H₂SO₄). When such a solvent is used as the stripping agent, the concentration of nitric acid (HNO₃) in the solution is preferably approximately 10 - 30 vol%, and the concentration of sulfuric acid H₂SO₄) is preferably approximately 10 - 30 vol%. This enables easily and reliably removing the first coating 3 in a relatively short time without actually damaging the base member 2.

The average thickness of the first coating 3 is not specifically limited but is preferably 0.1 - 5.0 µm, is further preferably 0.2 - 3.0 µm, and is yet further preferably 0.3 - 0.8 µm.

If the average thickness of the first coating 3 is a value within the foregoing range, the hardness of the decorative article 1 is rendered sufficiently high, an increase in Internal stress in the first coating 3 can be more effectively prevented, and as a result the decorative article 1 can be rendered with particularly outstanding reliability and durability.

However, if the average thickness of the first coating 3 is less than the lower limit of the foregoing range, it is difficult, depending upon the composition of the first coating 3 (such as the N content), to sufficiently achieve the desired function of the first coating 3.

Furthermore, if the average thickness of the first coating 3 exceeds the upper limit of the foregoing range, internal stress in the first coating 3 tends to rise depending upon the composition of the first coating 3 (such as the N content).

The first coating 3 may also have a plurality of regions with different compositions. For example, the first coating 3 may have a first region where the N content is a predetermined value X, and a second region where the N content is a predetermined X' that is greater than X. By rendering the first area on the base member 2 side of the second area in this configuration, an increase in the internal stress of the first coating 3 can be more effectively prevented while the hardness of the first coating 3 can be further increased, and particularly outstanding adhesion can be achieved between the base member 2 and first coating 3. As a result, the decorative article 1 can maintain a stable, particularly outstanding appearance over a longer time.

Furthermore, by rendering a second region where the sum of the C content and N content is relatively high, the hardness of the overall first coating 3 (the hardness of the entire decorative article 1) is particularly outstanding while the effect of the relatively dark toned second region on the aesthetic appearance of the decorative article 1 can be reduced.

More specifically, by disposing the first region on the second coating 4 of the second region (the side towards the outside of the decorative article), the appearance of the decorative article 1 is affected more by the tone of the first region than by the tone of the second region. The hardness of the overall first coating 3 (the hardness of the entire decorative article 1) is therefore particularly outstanding while the appearance of the decorative article 1 is also rendered particularly outstanding. The decorative article 1 can therefore retain a stable, outstanding appearance for a longer time.

If the first coating 3 has a plurality of regions of different compositions (such as when it has a first region and second region as described above), the first coating 3 may be a laminate having a plurality of layers of different compositions, or the composition may vary in a gradient through the thickness of the layer.

The first coating 3 is shown rendered over the entire surface of the base member 2 in the embodiment shown in the figure, but only needs to be formed on at least a part of the base member 2.

* Second coating

The second coating 4 is disposed on the surface of the first coating 3 (on the opposite side as the side facing the base member 2).

The second coating 4 is primarily Au, and is an Au-Pd-Ag-In alloy containing 6.0 - 9.0 wt% Pd, 6.0 - 8.0 wt% Ag, and 7.0 - 9.0 wt% In.

Disposing a second coating 4 with this composition, the decorative article 1 has an outstanding appearance with a pale gold color and sufficiently good corrosion resistance. In addition, when the second coating 4 is an Au-Pd-Ag-In alloy as described above, adhesion between the first coating 3 and second coating 4 is particularly outstanding. As a result, the decorative article 1 has an outstanding appearance and excellent durability, providing an outstanding appearance that is stable for a long time.

Au, Pd, Ag, and In are generally considered hypoallergenic and rarely cause an allergic reaction. The present invention can therefore be desirably used in accessories, such as watches, that are used in contact with the skin.

However, if the content of each of the elements in this Au-Pd-Ag-In alloy is outside the foregoing ranges, it is difficult to achieve a decorative article 1 having sufficient durability and an outstanding appearance with a pale gold color.

As described above, the Pd content is 6.0 - 9.0 wt%. If the Pd content is less than the lower limit of this range, hardness is insufficient and corrosion resistance is poor. In addition, if the Pd content is less than the lower limit of this range, the tone of the decorative article 1 will have a strong yellowish cast, and a sufficiently outstanding appearance cannot be achieved.

If the Pd content exceeds the upper limit of this range, internal stress increases in the second coating 4 and cracks occur easily. In addition, if the Pd content exceeds the upper limit of this range, the tone of the decorative article 1 will have a strong whitish cast, and a sufficiently outstanding appearance cannot be achieved.

As described above, the Ag content is 6.0 - 8.0 wt%. If the Ag content is less than the lower limit of this range, the second coating 4 becomes brittle. In addition, if the Ag content is less than the lower limit of this range, the tone of the decorative article 1 will have a strong yellowish cast, and a sufficiently outstanding appearance cannot be achieved.

If the Ag content exceeds the upper limit of this range, sufficient corrosion resistance cannot be achieved. In addition, if the Ag content exceeds the upper limit of this range, the tone of the decorative article 1 will have a strong whitish cast, and a sufficiently outstanding appearance cannot be achieved. Furthermore, if the Ag content exceeds the upper limit of this range, sufficiently strong adhesion cannot be achieved between the first coating 3 and second coating 4, and the decorative article 1 cannot be rendered with sufficiently outstanding durability.

As described above, the In content is 7.0 - 9.0 wt%. If the In content is less than the lower limit of this range, the tone of the decorative article 1 will have a strong yellowish cast, and a luxurious, pale gold appearance cannot be achieved. In addition, if the In content is less than the lower limit of this range, sufficiently strong adhesion cannot be achieved between the first coating 3 and second coating 4, and the decorative article cannot be rendered with sufficiently outstanding durability.

If the In content exceeds the upper limit of this range,internal stress increases in the second coating 4 and cracks occur easily. In addition, if the In content exceeds the upper limit of this range, the tone of the decorative article 1 will have a strong whitish cast, and a sufficiently outstanding appearance cannot be achieved.

As described above, the Au-Pd-Ag-In alloy used for the second coating 4 is primarily Au. The Au content in the second coating 4 is not specifically limited but is preferably 76.0 - 80.0 wt%, is further preferably 76.5 - 79.5 wt%, and is yet further preferably 77.0 - 79.0 wt%.

As also described above, the Pd content is 6.0 - 9.0 wt%, is preferably 6.2 - 8.4 wt%, and is yet further preferably 6.5 - 8.0 wt%. If the Pd content is within the foregoing range, the decorative article 1 can be rendered with a particularly outstanding appearance and durability.

As also described above, the Ag content is 6.0 - 8.0 wt%, is preferably 6.3 - 7.6 wt% , and is further preferably 6.5 - 7.3 wt%. If the Ag content is within the foregoing range, the decorative article 1 can be rendered with a particularly outstanding appearance and durability.

In addition, as described above, the In content is 7.0 - 9.0 wt%, but is preferably 7.3 - 8.6 wt%, and is further preferably 7.4 - 8.2 wt%. If the In content is within the foregoing range, the decorative article 1 can be rendered with a particularly outstanding appearance and durability.

The Au-Pd-Ag-In alloy used for the second coating 4 may contain elements other than Au, Pd, Ag, and In (also referred to below as the "essential elements"). Such elements (elements other than the essential elements) include, for example, Mg, Cr, Mn, Mo, Nb, W, Al, Au, Fe, V, Zr, and Sn. One or two or more of these elements may be used together.

If the second coating 4 contains elements other than the essential elements, Sn is particularly preferred in the foregoing group of elements. Furthermore, if the alloy rendering the second coating 4 contains an element other than the essential elements, the content of that added element (the total amount of the added elements if two or more are added) is preferably 1.5 wt% or less, and further preferably 1.0 wt% or less. The effects described above canbe achieved more reliably if the content of the essential elements is thus sufficiently high.

Further preferably, the second coating 4 does not contain any Ni. By rendering the second coating 4 without containing any Ni, the decorative article 1 can be rendered extremely resistant to causing allergic reactions, that is, hypoallergenic. As a result, the decorative article 1 is well suited to use as an external part of a watch (such as the case member (including the case member, the back cover, and a one-piece case including the case member and back cover in unison), watch bands (including the clasp, and the band-buckle coupling mechanism), the bezel (such as the rotating bezel), and the crown (such as a screw-lock type crown), and buttons) that comes in contact with the skin during use, and particularly parts that are in contact with the skin for extended periods of time.

The content of Ni in the second coating 4 is preferably 100 ppm or less, and further preferably 50 ppm or less. This enables the foregoing effect to be more reliably achieved.

The average thickness of the second coating 4 is not specifically limited but is preferably 0.02 - 2.0 µm, is further preferably 0.03 - 0.8 µm, and is yet further preferably 0.05 - 0.20 µm.

If the average thickness of the second coating 4 is less than the foregoing lower limit, pinholes occur easily in the second coating 4 and the effect of the invention cannot be sufficiently achieved.

If the average thickness of the second coating 4 exceeds the foregoing upper limit, internal stress in the second coating 4 rises, adhesion between the first coating 3 and second coating 4 drops, and cracks occur easily. In addition, if the average thickness of the second coating 4 exceeds the foregoing upper limit, the hardness of the decorative article 1 tends to drop.

Rendering the second coating 4 as described above gives the decorative article 1 excellent surface smoothness. This reduces or prevents surface roughness, and reduces or prevents discomfort or irritation when the decorative article touches the skin.

The composition of each part of the second coating 4 may be the same or not the same. For example, the composition of the second coating 4 may vary gradually (in a gradient) through the thickness of the second coating 4.

The second coating 4 may further alternatively be a laminate having a plurality of layers of different compositions.

The second coating 4 is shown rendered over the entire surface of the first coating 3 in the embodiment shown in the figure, but may be formed on only a part of the first coating 3.

* Decorative articles

The decorative article 1 described above can be any kind of decorative product such as decorative figurines and other interior design goods, exterior design goods, jewelry; watch cases (including the case member, back cover, and one-piece cases including the case member and back cover in unison), watch bands (including the clasp, and the band-buckle coupling mechanism), the dial, timepiece hands, the bezel (such as the rotating bezel), and the crown (such as a screw-lock type crown), buttons, the crystal, glass frames, dial rings, spacers, packing, and other external timepiece parts; the base plate of the movement, wheels and wheel train bridges, the rotor and other internal timepiece parts; eyeglasses (such as the frame), necktiepins, cuff links, rings, necklaces, bracelets, anklets, broaches, pendants, earrings, pierced earrings, and other personal accessories; lighters and lighter cases, car tire rims, golf clubs and other sporting gods, name plates, panels, trophy cups, mechanical parts including housings, and various types of containers. Of these, the invention is particularly suited to external timepiece parts.

External parts for timepieces require a beautiful appearance as decorative articles while also being utilitarian articles requiring durability, corrosion resistance, scratch resistance, wear resistance, and a particularly pleasing texture, and all of these conditions can be met by the present invention.

Note that an external timepieces part as used herein is any part that is visible from the outside, is not limited to parts exposed on the outside of a timepiece, and may be a part that is used inside the timepiece.

The Vickers hardness Hv measured with a 10 gf load on the side of the decorative article 1 to which the second coating 4 is disposed is preferably 500 - 1000, and is further preferably 550 - 800. This enables retaining outstanding appearance as a decorative article for a longer time.

Using the L*a*b* chromaticity diagram specified in JIS Z8729, the color tone of the surface of the decorative article 1 to which the second coating 4 is disposed is preferably in the range of a* = 0.7 - 2.9 and b* = 12.3 - 16.9, further preferably in the range a* = 0.8 - 1.8 and b* = 14.1 - 16.0, and yet further preferably in the range a* = 1.1 - 1.5 and b* = 14.3 - 15.8. This achieves a decorative article 1 with a particularly outstanding appearance.

Using the L*a*b* color chart specified in JIS Z8729, the color tone of the surface of the decorative article 1 to which the second coating 4 is disposed preferably has an L* in the range of L* = 84.2 - 88.4, further preferably in the range L* = 84.5 - 87.8, and yet further preferably in the range L* = 85.2 - 86.8. This achieves a decorative article with a particularly outstanding appearance.

A methed of manufacturing the decorative article 1 described above is described next.

FIG. 2 is a section view showing a preferred embodiment of the method of manufacturing the decorative article shown in FIG. 1.

As shown in FIG. 2, the method of manufacturing a decorative article according to this embodiment of the invention includes a first coating formation process (2b) that forms the first coating 3 on at least a part (2a) of the base member 2 surface, and a second coating formation process (2c) that forms the second coating 4 on at least a part of the first coating 3.

* Base member

A member such as described above can be used as the base member 2.

The method of manufacturing the base member 2 is not specifically limited.

Manufacturing methods that can be used when the base member 2 is made from a metal material include pressing, cutting and grinding, forging, casting, powder metallurgy annealing, metal powder injection molding (MIM), and lost wax casting. Of these, casting and metal powder injection molding (MIM) are particularly desirable. Casting and metal powder injection molding (MIM) in particular offer excellent processing characteristics. As a result, a base member 2 with a complex shape can be manufactured relatively easily using these methods.

A typical metal powder injection molding (MIM) process is described below.

First, a material containing metal powder and an organic binder are mixed and kneaded to produce a kneaded mixture. A molding is then made by injection molding this kneaded mixture. A degreasing process (debindering process) is then applied to this molding to obtain; a degreased molding. This degreasing process is typically done by heating the molding under vacuum conditions. The cleaned molding is then sintered to get a sintered body. This sintering process is usually at a higher temperature than the degreasing process. The sintered body resulting from this process can be used as the base member of the present invention.

If the base member 2 is made from one of the above plastic materials, it can be manufactured by such methods as compression molding, extrusion molding, injection molding, and shape deposition manufacturing.

If the base member 2 is made from one of the above ceramic materials the invention shall not be particularly limited to any particular manufacturing technique, but metal injection molding (MIM) is preferable. Metal powder injection molding (MIM) in particular offers excellent processing characteristics, and a base member 2 with a complex shape can therefore be manufactured relatively easily.

When the base member 2 has a base part and a surface layer as described above, the base member 2 can be manufactured as described below. More specifically, the base member 2 is obtained by forming a surface layer on top of a base layer that is manufactured as described above. The surface layer can be formed by coating methods such as dipping, brushing, spraying, electrostatic coating, and electrodeposition coating; wet plating methods such as electrolytic plating, immersion plating, and electroless plating; chemical vapor deposition (CVD) methods such as thermal CVD, plasma CVD, and laser CVD methods; dry plating methods such as vacuum deposition, sputtering, and ion plating; any spray coating methods.

The surface of the base member 2 is preferably processed by planishing, embossing, satinizing, or other surface processing method. These processes make it possible to vary the surface luster of the decorative article 1, and can further improve the decorativeness of the resulting decorative article 1. Furthermore, compared with a decorative article 1 that results from surface processing the first coating 3 or second coating 4 directly, a decorative article 1 that is manufactured using a base member 2 to which the desired surface processing technique is applied can be made to be less glittering and can thus be rendered with a particularly outstanding appearance.

Furthermore, because the first coating 3 is made from a hard TiN alloy, the first coating 3 can be easily chipped or damaged during surface treatment if the surface treatment is applied directly to the first coating 3, and the production yield of the decorative article 1 may drop dramatically. This problem can be effectively prevented, however, by applying the surface processing treatment to the base member 2. Surface treatment of the base member 2 can also occur more easily under temperate conditions than can surface processing of the first coating 3.

In addition, because the second coating 4 is normally relatively thin, applying a surfacing process after the second coating 4 is formed results in an extremely thin second coating wherever it is so processed and can even expose the first coating. When this happens the appearance of the decorative article 1 is significantly impaired.

The base member 2 can also be pretreated before forming the first coating 3 described above in order to improve adhesion between the base member 2 and first coating 3. Pretreatment processes include cleaning by blasting, alkaline cleaning, acid cleaning, water washing, organic solvent cleaning, and bombardment cleaning, or etching.
Particularly good adhesion between the base member 2 and first coating 3 can be achieved by applying a cleaning process.

* First coating formation process

A first coating 3 of primarily TiN is formed on the surface of the base member 2 (2b).

The method of forming the first coating 3 is not specifically limited, and various coating methods, wet plating methods, chemical vapor deposition (CVD) methods, dry plating methods (vapor phase epitaxy), and spray coating methods can be used, but a dry plating method (vapor phase epitaxy) is preferred. Examples of coating methods include spin coating, dipping, brushing, spray coating, electrostatic coating, and electrodeposition coating. Examples of wet plating methods include electrolytic plating, immersion plating, and electroless plating. CVD methods include thermal CVD, plasma CVD, and laser CVD methods. Dry plating methods include vacuum deposition, sputtering, and ion plating.

Using a dry plating method (vapor phase epitaxy) to form the first coating 3 enables forming a homogenous first coating 3 with uniform film thickness and particularly outstanding adhesion with the base member 2. The appearance and durability of the resulting decorative article 1 are therefore particularly outstanding.

Furthermore, using a dry plating method to form the first coating 3 enables minimizing variation in the film thickness even when the first coating 3 is relatively thin. This is also effective for improving the reliability of the decorative article 1. Furthermore, using a dry plating method to form the first coating 3 also enables more reliably controlling the N content (and the C content) of the first coating 3.

Among the group of dry plating methods noted above, ion plating is particularly preferred. The effects described above are particularly dramatic when ion plating is used as the method of forming the first coating 3. More particularly, using ion plating to form the first coating 3 enables forming a homogenous first coating 3 with uniform film thickness and particularly outstanding adhesion with the base member 2. The appearance and durability of the resulting decorative article 1 are therefore particularly outstanding.

Furthermore, using ion plating as the method of forming the first coating 3 enables minimizing variation in the film thickness even when the first coating 3 is relatively thin. This is also effective for improving the reliability of the decorative article 1. Furthermore, using an ion plating method to form the first coating 3 also enables more reliably controlling the N content (and the C content) of the first coating 3.

When a dry plating method such as described above is used, the first coating 3 can be formed easily and reliably by using a is target and a N (nitrogen) processing environment. Nitrogen (N₂), for example, can be used as the process gas in this case. The composition (N content) of the formed first coating 3 can also be adjusted by, for example, adjusting the pressure of the gas environment.

The process gas may also contain an inert gas such as argon. This enables easily and reliably controlling the N content of the first coating 3 to a relatively low level.

Furthermore, by including a gas containing C (carbon), such as acetylene or other hydrocarbon gas, in the process gas, a predetermined amount of C (carbon) can also be desirably included in the formed first coating 3. More particularly, a first coating 3 of TiCN can be formed.

A gas containing O (oxygen) (such as pure oxygen (O₂)) may also be included in the process gas. This enables easily and reliably forming a first coating 3 with a composition containing oxygen (such as TiNO or TiCMO).

* Second coating formation process

A second coating 4 made from an Au-Pd-Ag-In alloy is formed on the surface of the first coating 3 formed as described above (2c).

The second coating 4 is formed using a dry plating method (vapor phase epitaxy).

Using a dry plating method renders a second coating 4 with outstanding adhesion to the first coating 3. As a result, the finished decorative article 1 has particularly out standing corrosion resistance and durability. Furthermore, using a dry plating method enables forming a high density second coating 4. As a result, the second coating 4 has high luster and a particularly outstanding appearance.

Using a dry plating method enables easily and reliably rendering the composition of the formed second coating 4 with the same composition as the material (target) used for film formation. This is conceivably because the Au-Pd-Ag-In alloy is an extremely stable alloy, and any single component (element) in the material used for film formation (the target) is prevented from becoming gas particles more than the other components.

If the composition of the formed second coating does not satisfy the foregoing condition, it is difficult to render the composition of the formed second coating with the same composition as the material used for film formation (target), determin-ing the composition of the material used for film formation and setting the process conditions become complicated, and the resulting film becomes less reliable (in terms of the uniformity of the composition, for example).

Furthermore, a plurality of targets of different compositions may conceivably be used to form the second coating using a dry plating method if the composition of the second coating to be formed does not satisfy the foregoing condition and it is therefore difficult to form a stable alloy, but the reliability of the resulting decorative article is low because of the difficulty reliably preventing unintended variation in the composition at different parts of the second coating and unintended variation between individual finished articles.

Furthermore, using a dry plating method enables achieving a uniform film thickness even if the thickness of the second coating 4 is relatively thin.

Yet further, using a dry plating method enables achieving easily and reliably forming the second coating 4 even when the second coating 4 has a complex composition including an element other than the essential elements.

Examples of dry plating methods include vacuum deposition, sputtering, CVD methods such as thermal CVD, plasma CVD, and laser CVD methods, ion plating, and ion injection, and of these sputtering in particular is preferred.

Using sputtering as the dry plating method renders a finished decorative article 1 with a particularly outstanding appearance. In addition, by using sputtering as the dry plating method, any single component (element) in the Au-Pd-Ag-In alloy used as the target is prevented from becoming gas particles more than the other components, and a second coating 4 with a composition with long-term stability can be formed. As a result, the second coating 4 can be rendered without unintended variation in the composition at different parts of the coating and unintended variation between individual finished articles can be prevented, and a decorative article 1 with particularly high reliability can be achieved.

Furthermore, if the first coating is formed by a dry plating method, the first coating formation process and the second coating formation process can be executed consecutively using the same device (without removing the base member 2 from the process chamber) by, for example, changing the target and the composition of the process gas in the vapor phase epitaxy system (inside the chamber) . Adhesion between the base member 2, first coating 3, and second coating 4 is thus particularly outstanding, and productivity of the decorative article 1 can be improved.

A second embodiment of a decorative article according to the present invention, and a preferred method of manufacturing this decorative article, are described next.

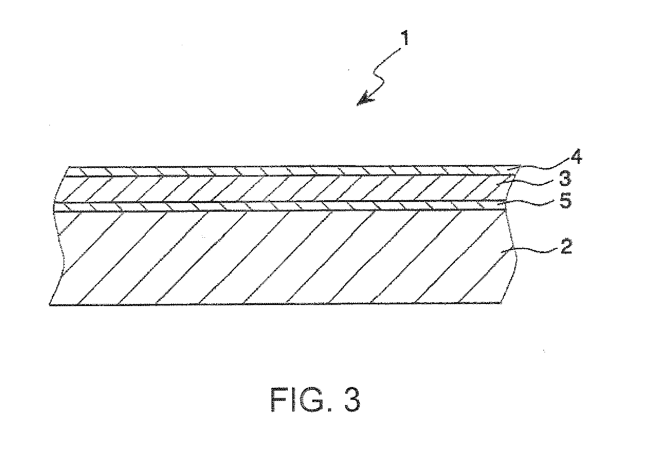

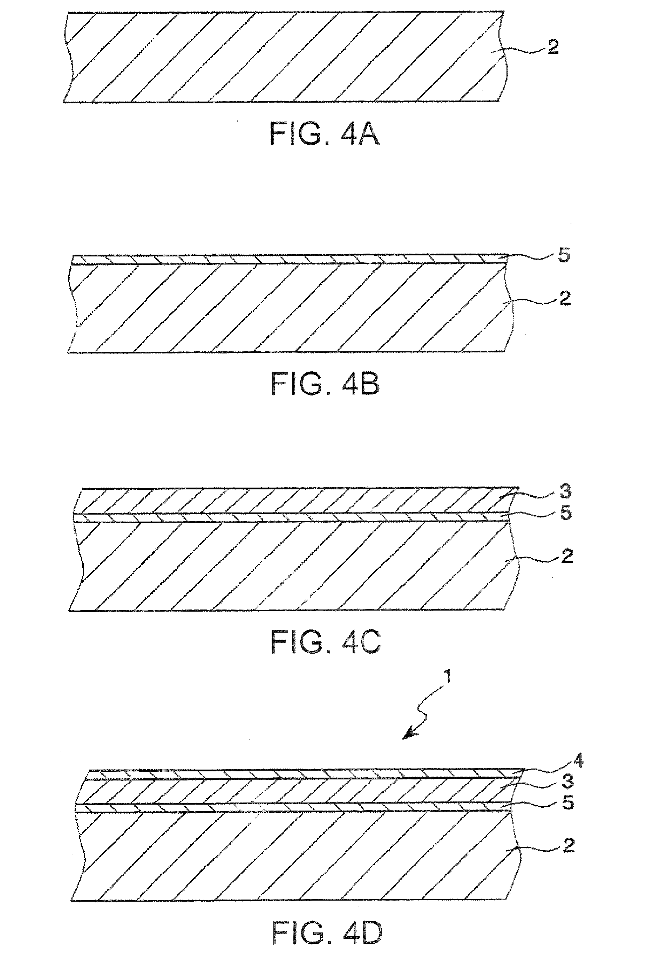

FIG. 3 is a section view showing a second embodiment of a decorative article according to the invention, and FIG. 4 is a section view describing a preferred embodiment of a method of manufacturing the decorative article.

The decorative article and method of manufacturing according to this embodiment of the invention are described below with particular attention to the difference with the foregoing embodiment, and further description of like parts is omitted or simplified below.

As shown in FIG. 2, a decorative article 1 according to this embodiment of the invention has a base member 2, a base layer 5 formed on the surface of the base member 2, a first coating 3 disposed on the surface of the base layer 5, and a second coating 4 formed on the surface of the first coating 3. More specifically, except for having a base layer 5 between the base member 2 and first coating 3, this decorative article 1 is identical to the decorative article according to the first embodiment described above. The base layer 5 is therefore described below.

* Base layer

The base layer 5 can be rendered to provide any desired function, such as improving adhesion between the base member 2 and first coating 3 (functioning as an adhesion improvement layer), repairing damage to the base member 2 by levelling (functioning as a levelling layer), or functioning to buffer external shocks to the finished decorative article (functioning as a cushioning layer).

Materials that can be used for the base layer 5 include metals such as Ti, Zr, Hf, V, Nb, Ta, Cr, and Al, and alloys containing at least one of these, but Ti is preferred.

If the base layer 5 is made of primarily Ti, adhesion between the base member 2 and first coating 3 can be further improved, and the reliability and durability of the decorative article 1 can be made particularly outstanding.

Furthermore, if the base layer 5 is made of primarily Ti, its function as a levelling layer smoothing the surface roughness of the base member 2 is particularly pronounced.

Furthermore, if the base layer 5 is made of primarily Ti, the base layer 5 functions more effectively as a cushioning layer buffering external impact to the base member 2, and the decorative article 1 can be made particularly resistant to denting, for example.

The average thickness of the base layer 5 is not specifically limited, but is preferably in the range 0.03 - 1.5 µm, and further preferably in the range 0.1 - 0.5 µm. If the average thickness of the base layer 5 is within the foregoing range, an increase in internal stress in the base layer 5 and cracks can be effectively prevented while the above-described function of the base layer 5 is more effective.

A method of manufacturing this decorative article 1 is described next.

FIG. 4 is a section view describing a preferred embodiment of a method of manufacturing the decorative article shown in FIG. 3.

As shown in FIG. 4, the method of manufacturing the decorative article according to this aspect of the invention includes a base layer formation process (4b) that forms the base layer 5 on at least a part (4a) of the base member 2 surface, a first coating formation process (4c) that forms the first coating 3 on at least a part (2a) of the base layer 5, and a second coating formation process (4d) that forms the second coating 4 on at least a part of the surface of the first coating 3. Note that other than forming the base layer 5 before forming the first coating 3, this method of manufacturing is the same as the manufacturing method described above.

* Base layer formation process

The base layer 5 is formed on the surface of the base member 2 in this embodiment of the invention (4b).

The method of forming the base layer 5 is not specifically limited, and various coating methods, wet plating methods, chemical vapor deposition (CVD) methods, dry plating methods (vapor phase epitaxy), and spray coating methods can be used, but a dry plating method is preferred. Examples of coating methods include spin coating, dipping, brushing, spray coating, electrostatic coating, and electrodeposition coating. Examples of wet plating methods include electrolytic plating, immersion plating, and electroless plating. CVD methods include thermal CVD, plasma CVD, and laser CVD methods. Dry plating methods include vacuum deposition, sputtering, and ion plating.

Using a dry plating method to form the base layer 5 enables forming a homogenous base layer 5 with uniform film thickness and particularly outstanding adhesion with the base member 2. The appearance and durability of the resulting decorative article 1 are therefore particularly outstanding.

Furthermore, using a dry plating method to form the base layer 5 enables minimizing variation in the film thickness even when the base layer 5 is relatively thin. This is also effective for improving the reliability of the decorative article 1.

Furthermore, if the first coating is formed by a dry plating method, the base layer formation process and the first coating formation process can be executed consecutively using the same device (without removing the base member 2 from the process chamber) by, for example, changing the target and the composition of the process gas in the vapor phase epitaxy system (inside the chamber). Adhesion between the base member 2, base layer 5, and first coating 3 is thus particularly outstanding, and productivity of the decorative article 1 can be improved.

In addition, if the base layer 5 is made of Ti, the base layer 5 and first coating 3 can be particularly desirably formed one after the other (continuously) by using the same target and changing the composition of the process gas in the vapor phase epitaxy system (inside the chamber).

A timepiece according to the invention incorporating a decorative article according to the invention is described next.

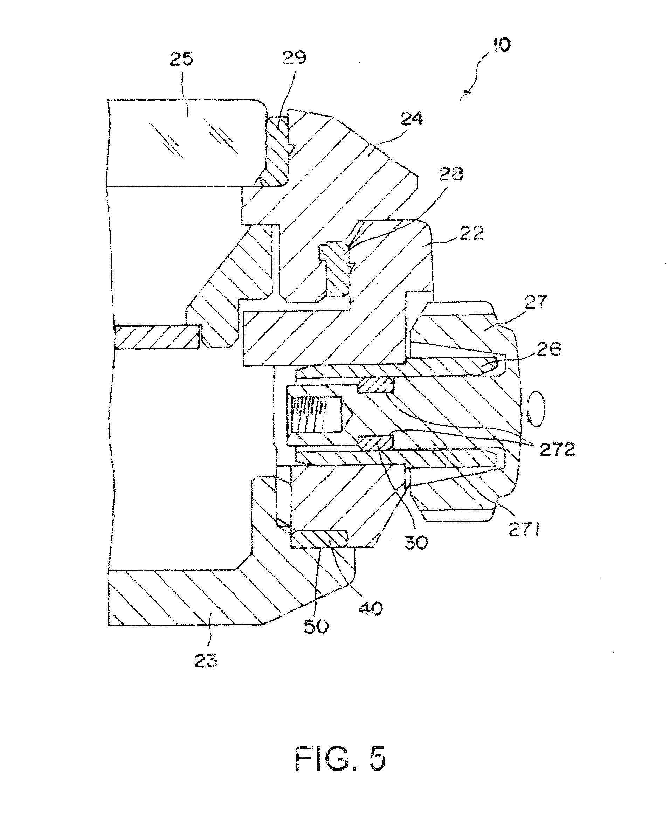

FIG. 5 is a partial section view showing a preferred embodiment of a timepiece (a portable timepiece) according to the present invention.

As shown in FIG. 5, a wristwatch (portable timepiece) 10 according to this embodiment of the invention has a case member 22, a back cover 23, a bezel 24, and a glass crystal 25. A movement not shown (such as an analog movement having a dial and hands) is housed inside the case member 22.

A stem pipe 26 is fit and fastened to the case member 22, and the stem 271 of the crown 27 is inserted freely rotatably inside the stem pipe 26.

The case member 22 and bezel 24 are fastened by plastic packing 28, and the bezel 24 and glass crystal are secured by plastic packing 29.

The back cover 23 is fit (or threaded) to the case member 22, and a rubber O-ring (back cover packing) 40 is compressed and inserted to the connection (seal) 50 therebetween. This makes the seal 50 watertight and imparts water resistance.

A groove 272 is formed around the outside of the middle part of the stem 271 of the crown 27, and an O-ring (crown packing) 30 is fit into this groove 272. The O-ring 30 fits tight to the inside surface of the stem pipe 26, and is compressed between this inside surface and the inside surface of the groove 272. This forms a watertight seal between the crown 27 and the stem pipe 2 6, and provides water resistance. When the crown 27 is wound, the O-ring 30 turns with the stem 271 and slides circumferentially along the inside surface of the stem pipe 26.

In a wristwatch 10 according to this embodiment of the invention at least one of group of decorative articles (particularly external parts of the timepiece) including the bezel 24, case member 22, crown 27, back cover 23, and wristband is a decorative article according to the invention described above.

Preferred embodiments of the invention are described above, but the invention is not so limited.

For example, the method of manufacturing the decorative article according to the invention may include other steps for particular purposes as required. For example, an intermediate process such as a cleaning process may be inserted between the first coating formation process and the second coating formation process, or between the base layer formation process and first coating formation process. A pretreatment process including cutting, grinding, polishing, or honing, for example, may also be applied to the base member.

The foregoing embodiments are described with reference to an embodiment forming the first coating by means of vapor phase film deposition, but the first coating may be formed by applying a nitriding process to a film made of Ti.

A protective layer imparting corrosion resistance, weather resistance, water resistance, oil resistance, scratch resistance, wear resistance, or resistance to color change can also be formed on at least part of the surface of the decorative article to improve protection against rust, soiling, dulling, and scratching. This protective coating may also be a coating this is removed when the decorative article is used, for example.

The invention is also described above with the first coating and second coating in contact with each other, but one or more intermediate layers may be disposed between the first coating and second coating. This can be used, for example, to further improve adhesion between the first coating and second coating.

Specific embodiments of the present invention are described next.

1. Manufacturing a decorative article

(Embodiment 1)

A decorative article, specifically part of a wristwatch case (the back cover), was manufactured by the method described below.

A base member having the desired shape of a wristwatch case (back cover) was manufactured by a casting technique using stainless steel (SUS 444), and then ground and polished as required.

This base member was then cleaned. The base material was cleaned by alkali electrolytic degreasing for 30 seconds followed by alkali dipping degreasing for 30 seconds. Then followed neutralization for 10 seconds, a water wash for 10 seconds, and a demineralized water wash for 10 seconds.

Using a vapor phase epitaxy system as described above, a first coating of primarily Ti was formed on the cleaned base member as described below.

First, the process chamber of the vapor phase epitaxy system was vented (reduced) to 2 x 10⁻³ Pa while preheating the chamber after the cleaned base member was placed in the chamber of the vapor phase epitaxy system.

Argon gas for cleaning was then introduced to the chamber and the workpiece was cleaned for 5 minutes by applying a 350 DC voltage.

Next, after venting (reducing) the chamber to 2 x 10⁻³ Pa, nitrogen gas was introduced at a flow rate of 40 ml/min and the gas pressure (total pressure) inside the chamber was adjusted to 1.8 x 10⁻³ Pa. While then continuing to supply nitrogen gas, ion plating (first coating formation process) using a Ti target commenced and continued for 19 minutes using a 50-V ionization voltage and 40-A ionization current. This produced a TiN first coating with an average thickness of 0.5 µm. The N content of the resulting first coating was 15.0 wt%.

A second coating of an Au-Pd-Ag-In alloy was then formed on the surface of the first coating by sputtering using the foregoing vapor phase epitaxy system (second coating formation prooess). The second coating was formed as described below.

First, the process chamber of the vapor phase epitaxy system was vented (reduced) to 1.0 x 10⁻¹ Pa while preheating the chamber after the base member that is the sputtered first coating was placed in the chamber of the vapor phase epitaxy system.

Argon gas was then introduced at 40 ml/min, and a second coating of an Au-Pd-Ag-In alloy was formed by using an Au-Pd-Ag-In alloy as the target while discharging a 650-V, 2.0-A current for 5.0 minutes. The average thickness of the resulting second coating was 0.08 µm. The Au-Pd-Ag-In alloy used as the target and the Au-Pd-Ag-In alloy forming the second coating was a composition of 78.0 wt% Au, 7.0 wt% Pd, 7.0 wt% Ag, and 8.0 wt% In.

The thickness of the first coating and second coating were measured by the JIS H 5821 microscope cross-sectional test method.

(Embodiments 2 - 8)

Except for modifying the compositions of the first coating and the second coating in these embodiments as shown in Table 1 by adjusting the flow rate of the nitrogen gas supply and the process time in the first coating formation process, and adjusting the alloy composition of the target and the process time in the second coating formation process, decorative articles (wristwatch cases (back covers)) were manufactured in the same way as the first embodiment described above.

(Embodiment 9)

Except for rendering the first coating from TiCN by using nitrogen and acetylene as the process gas in the first coating formation process, a decorative article (wristwatch case (back cover)) was manufactured in the same way as the first embodiment described above.

The first coating formation process (ion plating) supplied nitrogen gas at 30 ml/min and acetylene at 20 ml/min, controlled the chamber pressure (total pressure) to 3 x 10⁻³ Pa, and set the ionization voltage to 50 V and the ionization current to 40 A.

(Embodiments 10 and 11)

Except for changing the flow rate of the nitrogen and acetylene process gas in the first coating formation process, and changing the process time of the first coating formation process, to change the average thickness of the first coating and the N content and C content of the first coating as shown in Table 1, decorative articles (wristwatch cases (back covers)) were manufactured in the same way as the ninth embodiment described above.

(Embodiment 12)

Except for using a Ti base member, a decorative article (wristwatch case (back cover)) was manufactured in the same way as the first embodiment described above.

The base member was manufactured by metal injection molding (MIM) as described below.

First, Ti powder with a 52 µm average grain size manufactured by a gas atomization method was prepared.

A material containing 75 vol% of this Ti powder, 8 vol% polyethylene, 7 vol% polypropylene, and 10 vol% paraffin wax was kneaded. A kneader was used to knead this material. The material temperature during kneading was 60°C.

The kneaded material was then ground and graded to obtain pellets with an average grain size of 3 mm. Using these pellets in an injecting molding machine, moldings in the shape of the wristwatch case were manufactured by metal injection molding (MIM) . The molding were made with consideration for shrinkage in the debindering process and during sintering. Molding conditions during injection molding were a 40°C mold temperature, 80 kgf/cm² injection pressure, 20 second injection time, and 40 second cooling time.

Next, a debindering process was applied to the molding using a degreasing oven to obtain a degreased molding. For the debindering process the molding was left in a 1.0 x 10⁻¹ Pa argon gas atmosphere at 80°C for 1 hour, and then raised to 400°C at 10°C/hour. Sample weight was measured during the heat treatment to find the point at which weight loss ended as the debindering completion point.

The resulting degreased molding was then sintered in a sintering oven to obtain the base member. Sintering was done by heating in a 1.3 x 10⁻³ to 1.3 x 10⁻⁴ Pa argon gas atmosphere at 900°C to 1100°C for 6 hours.

The base member thus obtained was then cut and polished as required, and the base member was then cleaned. The base member was cleaned by alkali electrolytic degreasing for 30 seconds followed by alkali dipping degreasing for 30 seconds. Then followed neutralization for 10 seconds, a water wash for 10 seconds, and a demineralized water wash for 10 seconds.

(Embodiments 13 to 17)

Except for modifying the compositions of the first coating and the second coating in these embodiments as shown in Table 1 by adjusting the flow rate of the nitrogen gas supply and the process time in the first coating formation process, and adjusting the alloy composition of the target and the process time in the second coating formation process, decorative articles (wristwatch cases (back covers)) were manufactured in the same way as embodiment 12 described above.

(Embodiment 18)

Except for rendering the first coating from TiCN by using nitrogen and acetylene as the process gas in the first coating formation process, a decorative article (wristwatch case (back cover)) was manufactured in the same way as embodiment 12 described above.

The first coating formation process (ion plating) supplied nitrogen gas at 30 ml/min and acetylene at 20 ml/min, controlled the chamber pressure (total pressure) to 3 x 10⁻³ Pa, and set the ionization voltage to 50 V and the ionization current to 40 A.

(Embodiments 19 and 20)

Except for changing the flow rate of the nitrogen and acetylene process gas in the first coating formation process, and changing the process time of the first coating formation process, to change the average thickness of the first coating and the N content and C content of the first coating as shown in Table 1, decorative articles (wristwatch cases (back covers)) were manufactured in the same way as embodiment 18 described above.

(Embodiment 21)

Except for forming the base layer on the base member before forming the first coating, a decorative article (wristwatch case (back cover)) was manufactured in the same way as embodiment 1 described above.

The base layer was formed as described below.

The workpiece or base member was prepared and cleaned as described in embodiment 1 above, and then placed inside the process chamber of the vapor phase epitaxy system.

The process chamber of the vapor phase epitaxy system was then vented (reduced) to 3 x 10⁻³ Pa while preheating the chamber.

Argon gas for cleaning was then introduced to the chamber and the workpiece was cleaned for 5 minutes by applying a 350 DC voltage.

Argon gas was then introduced to the process chamber at a pressure of 53 Pa and 400 VDC was applied and held for 30 - 60 minutes. While maintaining these conditions, a base layer of Ti was formed using a Ti target, 30-V ionization voltage, 20-A ionization current, and 20 minute process time (base layer formation process). The average thickness of the resulting base layer was 0.5 µm.

The thickness of the first coating, second coating, and base layer were measured by the JIS H 5821 microscope cross-sectional test method.

(embodiments 22 - 26)

Except for modifying the compositions of the first coating, the second coating, and the base layer in these embodiments as shown in Table 2 by adjusting the composition of the target and the process time of the base layer formation process, the flow rate of the nitrogen gas supply and the process time in the first coating formation process, and adjusting the alloy composition of the target and the process time in the second coating formation process, decorative articles (wristwatch cases (back covers)) were manufactured in the same way as embodiment 21 described above.

(Embodiment 27)

Except for rendering the first coating from TiCN by using nitrogen and acetylene as the process gas in the first coating formation process, a decorative article (wristwatch case (back cover)) was manufactured in the same way as embodiment 1 described above.

The first coating formation process (ion plating) supplied nitrogen gas at 30 ml/min and acetylene at 20 ml/min, controlled the chamber pressure (total pressure) to 3 x 10⁻³ Pa, and set the ionization voltage to 50 V and the ionization current to 40 A.

(Embodiments 28 and 29)

Except for changing the process time of the base layer formation process, changing the flow rate of the nitrogen and acetylene process gas in the first coating formation process, and changing the process time of the first coating formation process, to change the average thickness of the base layer, the average thickness of the first coating, and the N content and C content of the first coating as shown in Table 2, decorative articles (wristwatch cases (back covers)) were manufactured in the same way as embodiment 27 described above.

(embodiment 30)

Except for using a Ti base member, a decorative article (wristwatch case (back cover)) was manufactured in the same way as embodiment 21 described above.

The base member was manufactured by metal injection molding (MIM) as described below.

First, Ti powder with a 52 µm average grain size manufactured by a gas atomization method was prepared.

A material containing 75 vol% of this Ti powder, 8 vol% polyethylene, 7 vol% polypropylene, and 10 vol% paraffin wax was kneaded. A kneader was used to knead this material. The material temperature during kneading was 60°C.

The kneaded material was then ground and graded to obtain pellets with an average grain size of 3 mm. Using these pellets in an injecting molding machine, moldings in the shape of the wristwatch case were manufactured by metal injection molding (MIM) . The molding were made with consideration for shrinkage in the debindering process and during sintering. Molding conditions during injection molding were a 40°C mold temperature, 80 kgf/cm² injection pressure, 20 second injection time, and 40 second cooling time.

Next, a debindering process was applied to the molding using a degreasing oven to obtain a degreased molding. For the debindering process the molding was left in a 1.0 x 10⁻¹ Pa argon gas atmosphere at 80°C for 1 hour, and then raised to 400°C at 10°C/hour. Sample weight was measured during the heat treatment to find the point at which weight loss ended as the debindering completion point.

The resulting degreased molding was then sintered in a sintering oven to obtain the base member. Sintering was done by heating in a 1.3 x 10⁻³ to 1.3 x 10⁻⁴ Pa argon gas atmosphere at 900°C to 1100°C for 6 hours.

The base member thus obtained was then cut and polished as required, and the base member was then cleaned. The base material was cleaned by alkali electrolytic degreasing for 30 seconds followed by alkali dipping degreasing for 30 seconds. Then followed neutralization for 10 seconds, a water wash for 10 seconds, and a demineralized water wash for 10 seconds.

(Embodiments 31 to 35)

Except for modifying the compositions of the base layer, the first coating, and the second coating in these embodiments as shown in Table 2 by adjusting or selecting the composition of the target and the process time of the base layer formation process, the flow rate of the nitrogen gas supply and the process time in the first coating formation process, and the alloy composition of the target and the process time in the second coating formation process, decorative articles (wristwatch cases (back covers)) were manufactured in the same way as embodiment 30 described above.

(Embodiment 36)

Except for rendering the first coating from TiCN by using nitrogen and acetylene as the process gas in the first coating formation process, a decorative article (wristwatch case (back cover)) was manufactured in the same way as embodiment 30 described above.

The first coating formation process (ion plating) supplied nitrogen gas at 30 ml/min and acetylene at 20 ml/min, controlled the chamber pressure (total pressure) to 3 x 10⁻³ Pa, and set the ionization voltage to 50 V and the ionization current to 40 A.

(Embodiments 37 and 38)

Except for changing the process time of the base layer formation process, changing the flow rate of the nitrogen and acetylene process gas in the first coating formation process, and changing the process time of the first coating formation process, to change the average thickness of the base layer, the average thickness of the first coating, and the N content and C content of the first coating as shown in Table 2, decorative articles (wristwatch cases (back covers)) were manufactured in the same way as embodiment 36 described above.

(Embodiment 39)

Except for making the base member by casting a Cu-Zn alloy (containing 60 wt% Cu and 40 wt% Zn), a decorative article (wristwatch case (back cover)) was manufactured in the same way as embodiment 1 described above.

(Comparison 1)

Except for omitting the first coating formation process, a decorative article (wristwatch case (back cover)) was manufactured in the same way as embodiment 1 described above. In this comparison sample the second coating was formed directly on the surface of the base member.

(Comparison 2)

Except for omitting the second coating formation process, a decorative article (wristwatch case (back cover)) was manufactured in the same way as embodiment 1 described above. The decorative article according to this comparisons sample therefore included only the base member and first coating, and did not have the second coating described above.

(Comparison 3)

A decorative article (wristwatch case (back cover)) was manufactured by the method described below.

First, a Ti base member was prepared as described in embodiment 12.

The base member was then cleaned. The base member was cleaned by alkali electrolytic degreasing for 30 seconds followed by alkali dipping degreasing for 30 seconds. Then followed neutralization for 10 seconds, a water wash for 10 seconds, and a demineralized water wash for 10 seconds.

A carburization process was then applied to this cleaned base member to form a carburized layer (TiC) made of TiC.

Carburizing was done using the plasma carburization process described below.

A carburization system was prepared by placing a process chamber surrounded by insulation such as graphite fiber insulation in an oven, heating the process chamber using a heating element made of graphite rods, connecting the positive DC glow discharge terminal to the top of the process chamber, connecting the negative terminal to the workpiece stand, and disposing a gas manifold at the required location inside the chamber for appropriately introducing hydrocarbon, nitrogen, argon, hydrogen, or other process gases (including gas for carburization and a dilution gas).

Argon gas for cleaning was then introduced to the chamber for a 5 minute cleaning process applying a 350-V DC voltage.

Propane was then introduced to the chamber until the gas composition inside the chamber was substantially 100% propane, the gas pressure was adjusted to 53 Pa, and 400 DCV was applied and held for 90 - 180 minutes for plasma carburization. Argon and nitrogen gas was then pressure fed into the chamber to cool the base member to normal temperature. This carburization process produced a carburized layer approximately 15 µm thick.

The decorative article (wristwatch case (back cover)) was then produced by forming the second coating as described in embodiment 1 above on the surface of the carburized layer.

(Comparisons 4 - 18)

Except for changing the target used in the second coating formation process to change the composition of the second coating as shown in Table 3, decorative articles (wristwatch cases (back covers)) were produced as described in embodiment 1 above.

(Comparison 19)

Except for using an Au-Ni target instead of an Au-Pd-Ag-In alloy in the second coating formation process, a decorative article (wristwatch case (back cover)) was produced as described in embodiment 1 above.

(Comparison 20)

Except for omitting the first coating formation process, a decorative article (wristwatch case (back cover)) was produced as described in comparison 19 above.

The second coating formed in each of the embodiments described above has the same composition as the target (vapor source) used for its formation.

If a target having an In content exceeding the upper limit described above is used, the composition of the resulting second coating differs greatly from the composition of the target, and it is difficult to control the composition of the second coating.

More specifically, we confirmed that when a target having an In content exceeding the upper limit described above is used, the vapor particles contain an abundance of Ag, the Ag content of the second coating therefore becomes higher than the Ag content of the target, and the content of other components (particularly Pd and In) in the second coating becomes unstable.

The compositions of the foregoing embodiments and the comparison samples are shown in Table 1, Table 2, and Table 3. Note that in Tables 1 to 3 "SUS" denotes stainless steel, and BS denotes the Cu-Zn alloy. In addition, the values for the carburized layer formed by the carburization process in comparison 3 in Table 3 are shown in the column for the first coating.

In each of the embodiments and comparisons, the base member and base layer effectively contained only the components shown in the tables (the combined content of the components shown in the tables is 99.9 wt% or more in all cases). In addition, the Ni content of the second coating in each of the embodiments and comparisons 1 to 18 was 10 ppm or less.

**Table 1**

| | Base | Base coat | | First coating | | | | Second coating | | | | | |
|---|---|---|---|---|---|---|---|---|---|---|---|---|---|
| | Material | Material | Avg thick (µm) | Ti (wt%) | N (wt%) | C (wt%) | Avg thick (µm) | Content (wt%) | | | | | Avg thick (µm) |
| | | | | | | | | Au | Pd | Ag | In | Ni | |
| Embodiment 1 | SUS | | | 85.0 | 15.0 | | 0.5 | 75.0 | 7.0 | 7.0 | 8.0 | | 0.08 |
| Embodiment 2 | SUS | | | 91.6 | 8.4 | | 0.8 | 78.1 | 8.0 | 6.5 | 7.4 | | 0.06 |
| Embodiment 3 | SUS | | | 92.2 | 7.8 | | 3.7 | 77.0 | 7.5 | 7.3 | 8.2 | | 0.19 |
| Embodiment 4 | SUS | | | 89.5 | 10.5 | | 0.3 | 77.6 | 8.7 | 6.1 | 7.6 | | 0.04 |
| Embodiment 5 | SUS | | | 87.6 | 12.4 | | 0. 4 | 77.9 | 6.7 | 6.5 | 8.9 | | 0.13 |
| Embodiment 6 | SUS | | | 79.0 | 21.0 | | 0.7 | 78.0 | 6.1 | 7.9 | 8.0 | | 0.10 |
| Embodiment 7 | SUS | | | 76.9 | 23.1 | | 0.2 | 77.7 | 7.7 | 7.5 | 7.1 | | 0.23 |
| Embodiment 8 | SUS | | | 93.1 | 6.9 | | 0.6 | 76.7 | 8.3 | 6.4 | 5.6 | | 0.17 |
| Embodiment 9 | SUS | | | 79.0 | 15.8 | 5.2 | 0.6 | 78.0 | 7.0 | 7.0 | 8.0 | | 0.08 |
| Embodiment 10 | SUS | | | 82.8 | 8.3 | 3.9 | 0.7 | 78.0 | 7.0 | 7.0 | 8.0 | | 0.08 |
| Embodiment 11 | SUS | | | 74.7 | 16.0 | 9.3 | 0.5 | 87.0 | 7.0 | 7.0 | 8.0 | | 0.08 |
| Embodiment 12 | Ti | | | 85.0 | 15.0 | | 0.5 | 78.0 | 7.0 | 7.0 | 8.0 | | 0.88 |
| Embodiment 13 | Ti | | | 88.0 | 12.0 | | 2.2 | 78.3 | 7.2 | 6.7 | 7.8 | | 0.21 |
| Embodiment 14 | Ti | | | 91.6 | 8.2 | | 2.9 | 78.8 | 6.4 | 7.5 | 7.3 | | 0.12 |
| Embodiment 15 | Ti | | | 88.9 | 11.1 | | 0.7 | 78.1 | 3.6 | 6.2 | 7.1 | | 0.07 |
| Embodiment 16 | Ti | | | 87.5 | 12.5 | | 0.6 | 77.9 | 6.7 | 6.6 | 8.8 | | 0.09 |
| Embodiment 17 | Ti | | | 84.3 | 15.7 | | 0.5 | 77.3 | 6.4 | 7.4 | 8.3 | | 0.12 |
| Embodiment 18 | Ti | | | 79.0 | 15.8 | 5.2 | 0.6 | 78.0 | 7.0 | 7.0 | 8.0 | | 0.08 |
| Embodiment 19 | Ti | | | 81.7 | 10.5 | 7.3 | 0.4 | 78.0 | 7.0 | 7.0 | 8.0 | | 0.08 |
| Embodiment 20 | Ti | | | 85.7 | 7.6 | 6.7 | 0.5 | 78.0 | 7.0 | 7.0 | 8.0 | | 0.08 |

**Table 2**

| | Base | Base coat | | First coating | | | | Second coating | | | | | |
|---|---|---|---|---|---|---|---|---|---|---|---|---|---|
| | Material | Material | Avg thick (µm) | Ti (wt%) | N (wt%) | C (wt%) | Avg thick (µm) | Content (wt.%) | | | | | Avg thick (µm) |
| | | | | | | | | Au | Pd | Ag | In | Ni | |
| Embodiment 21 | SUS | Ti | 0.5 | 85.0 | 15.0 | | 0.5 | 78.0 | 7.0 | 7.0 | 8.0 | | 0.08 |
| Embodiment 22 | SUS | Ti | 0.2 | 91.6 | 8.4 | | 0.3 | 78.2 | 6.6 | 7.1 | 8.1 | | 0.15 |
| Embodiment 23 | SUS | Al | 0.6 | 91.4 | 8.6 | | 0.6 | 79.7 | 6.7 | 6.3 | 7.3 | | 0.23 |
| Embodiment 24 | 3US | Ti | 0.04 | 88.4 | 11.6 | | 0.7 | 78.5 | 8.3 | 6.0 | 7.2 | | 0.12 |
| Embodiment 25 | SUS | Al | 0.4 | 87.8 | 12.2 | | 0.8 | 76.7 | 6.9 | 7.7 | 8.8 | | 0.10 |
| Embodiment 26 | SUS | Ti | 0.3 | 83.9 | 16.1 | | 0.2 | 77.9 | 6.4 | 7.4 | 8.3 | | 0.14 |
| Embodiment 27 | SUS | Ti | 0.5 | 79.0 | 15.8 | 5.2 | 0.6 | 78.0 | 7.0 | 7.0 | 8.0 | | 0.08 |
| Embodiment 28 | SUS | Ti | 0.2 | 78.0 | 14.4 | 7.6 | 0.4 | 78.0 | 7.0 | 7.0 | 8.0 | | 0.08 |
| Embodiment 29 | SUS | Ti | 1.0 | 74.4 | 15.5 | 10.1 | 0.7 | 78.0 | 7.0 | 7.0 | 8.0 | | 0.08 |
| Embodiment 30 | Ti | Ti | 0.5 | 35.0 | 15.0 | | 0.5 | 78.0 | 7.0 | 7.0 | 8.0 | | 0.98 |
| Embodiment 31 | Ti | Ti | 0.5 | 84.4 | 15.6 | | 1.3 | 77.6 | 7.1 | 7.2 | 8.1 | | 0.11 |
| Embodiment 32 | Ti | Ti | 0.3 | 89.2 | 10.8 | | 0.7 | 77.3 | 7.8 | 7.7 | 7.2 | | 0.15 |
| Embodiment 33 | Ti | Ti | 0.7 | 87.3 | 12.7 | | 0.5 | 77.8 | 8.7 | 6.3 | 7.2 | | 0.13 |
| Embodiment 34 | Ti | Ti | 0.5 | 84.2 | 15.8 | | 0.3 | 78.6 | 6.9 | 6.8 | 7.7 | | 0.07 |
| Embodiment 35 | Ti | Al | 0.04 | 84.9 | 15.1 | | 0.3 | 79.0 | 6.1 | 7.0 | 7.9 | | 0.15 |
| Embodiment 36 | Ti | Ti | 0.5 | 79.0 | 15.8 | 5.2 | 0.6 | 78.0 | 7.0 | 7.0 | 8.0 | | 0.08 |
| Embodiment 37 | Ti | Ti | 0.1 | 81.4 | 9.7 | 8.9 | 0.2 | 78.0 | 7.0 | 7.0 | 8.0 | | 0.08 |
| Embodiment 38 | Ti | Ti | 0.7 | 81.6 | 9.6 | 8.8 | 0.7 | 78.0 | 7.0 | 7.0 | 8.0 | | 0.08 |
| Embodiment 39 | BS | | | 85.0 | 15.0 | | 0.5 | 78.0 | 7.0 | 7.0 | 8.0 | | 0.08 |

**Table 3**

| | Base | Base coat | | First coating | | | | Second coating | | | | | |
|---|---|---|---|---|---|---|---|---|---|---|---|---|---|
| | Material | Material | Avg thick thik (µm) | Ti (wt%) | N (wt%) | C (wt%) | Avg thick (µm) | Content (wt%) | | | | | Avg thick (µm) |
| | | | | | | | | Au | Pd | Ag | In | Ni | |
| Comparison 1 | SUS | | | | | | | 78.0 | 7.0 | 7.0 | 8.0 | | 0.08 |
| Comparison 2 | SUS | | | 85.0 | 15.0 | | 0.5 | | | | | | |
| Comparison 3 | Ti | | | 91.2 | | 8.8 | 15.0 | 78.0 | 7.0 | 7.0 | 8.0 | | 0.08 |
| Comparison 4 | SUS | | | 85.0 | 15.0 | | 0.5 | 78.9 | 5.9 | 7.1 | 8.1 | | 0.08 |
| Comparison 5 | SUS | | | 85.0 | 15.0 | | 0.5 | 78.0 | 5.9 | 7.5 | 8.6 | | 0.08 |
| Comparison 6 | SUS | | | 85.0 | 15.0 | | 0.5 | 83.8 | | 7.6 | 8.6 | | 0.08 |
| Comparison 7 | SUS | | | 85.0 | 15.0 | | 0.5 | 76.3 | 9.1 | 6.8 | 7.8 | | 0.08 |
| Comparison 13 | SUS | | | 85.0 | 15.0 | | 0.5 | 78.0 | 9.1 | 6.0 | 6.9 | | 0.08 |
| Comparison 9 | SUS | | | 85.0 | 15.0 | | 0.5 | 78.9 | 7.1 | 5.9 | 8.1 | | 0.08 |
| Comparison 10 | SUS | | | 85.0 | 15.0 | | 0.5 | 78.0 | 7.5 | 5.9 | 8.6 | | 0.08 |
| Comparison 11 | SUS | | | 85.0 | 15.0 | | 0.5 | 83.8 | 7.6 | | 8.6 | | 0.08 |
| Comparison 12 | SUS | | | 85.0 | 15.0 | | 0.5 | 77.1 | 6.9 | 8.1 | 7.9 | | 0.08 |
| Comparison 13 | SUS | | | 85.0 | 15.0 | | 0.5 | 78.0 | 6.5 | 8.1 | 7.4 | | 0.08 |
| Comparison 14 | SUS | | | 85.0 | 15.0 | | 0.5 | 78.9 | 7.1 | 7.1 | 6.9 | | 0.08 |
| Comparison 15 | SUS | | | 85.0 | 15.0 | | 0.5 | 78.0 | 7.6 | 7.5 | 6.9 | | 0.08 |
| Comparison 16 | SUS | | | 85.0 | 15.0 | | 0.5 | 84.7 | 7.7 | 7.6 | | | 0.08 |
| Comparison 17 | SUS | | | 85.0 | 15.0 | | 0.5 | 77.1 | 6.9 | 6.9 | 9.1 | | 0.08 |
| Comparison 18 | SUS | | | 85.0 | 15.0 | | 0.5 | 78.0 | 6.5 | 6.4 | 9.1 | | 0.08 |
| Comparison 19 | SUS | | | 85.0 | 15.0 | | 0.5 | 93.0 | | | | 7.0 | 0.08 |
| Comparison 20 | SUS | | | | | | | 93.0 | | | | 7.0 | 0.08 |

2. Visual evaluation of appearance

The appearance of each of the decorative articles manufactured as described in the embodiments and comparison samples above inspected visually and by microscope, and the appearance was graded using the five levels described below.
A: excellent appearance
B: good appearance
C: defects apparent
D: poor appearance
E: extremely poor appearance

3. Appearance evaluation using a spectrophotometer

3-1 Evaluation of a* and b*

The color of the surface on which the coating was formed was measured for each of the decorative articles manufactured as described in the above embodiments and comparison samples using a spectrophotometer (Minolta, CM-2022), and the color was graded in five levels as described below.
A: a* in the range -4 to 4 and b* in the range 14.3 to 15.8 in the L*a*b* color space defined in JIS Z 8729
B: a* in the range 0.8 to 1.8 and b* in the range 14.1 to 16.0 in the L*a*b* color space defined in JIS Z 8729 (except not including the range for grade A)
C: a* in the range 0.7 to 2.9 and b* in the range 12.3 to 16.9 in the L*a*b* color space defined in JIS Z 8729 (except not including the ranges for grades A and B)
D: a* in the range 0.4 to 3.0 and b* in the range 11.3 to 18.2 in the L*a*b* color space defined in JIS Z 8729 (except not including the ranges for grades A, B, and C)
E: a* in the range 0.4 to 3.0 and b* outside the range 11.3 to 18.2 in the L*a*b* color space defined in JIS Z 8729

The light source for the spectrophotometer was a D₆₅ light source defined in JIS Z 8720, and measurements were taken at a viewing angle of 2°.

3-2 Evaluation of L*

The color of the surface on which the coating was formed was measured for each of the decorative articles manufactured as described in the above embodiments and comparison samples using a spectrophotometer(Minolta, CM-2022), and the color was graded in five levels as described below.
A: L* in the range 85.2 - 86.8 in the L*a*b* color space defined in JIS Z 8729
B: L* in the range 84.5 - 87.8 in the L*a*b* color space defined in JIS Z 8729 (except not including the range for A)
C: L* in the range 84.2 - 88.4 in the L*a*b* color space defined in JIS Z 8729 (except not including the ranges for A and B)
D: L* in the range 83 .2 - 89.5 in the L*a*b* color space defined in JIS Z 8729 (except not including the ranges for A, B, and C)
E: L* outside the range 83.2 - 89.5 in the L*a*b* color space defined in JIS Z 8729

The light source for the spectrophotometer was a D₆₅ light source defined in JIS Z 8720, and measurements were taken at a viewing angle of 2°.

4. Long-term stability evaluation

The color tone on the side on which the coating was formed on the decorative article was measured for each of the decorative articles manufactured in the embodiments and comparisons described above using a spectrophotometer (Minolta, CM-2022) and evaluated according to the following four grades before and after storage for 80 days at normal temperature (20°C), normal pressure, and 80% RH.
A: color difference ΔE < 3
B: 3 ≤ color difference ΔE < 4
C: 4 ≤ color difference ΔE < 5
D: 5 ≤ color difference ΔE

The light source for the spectrophotometer was a D₆₅ light source defined in JIS Z 8720, and measurements were taken at a viewing angle of 2°.

5. oxidation resistance evaluation

The decorative articles manufactured in each of the embodiments and comparisons described above were left in a normal pressure atmosphere at 180°C for 12 hours, the color tone was then measured on the side on which the coating was formed on the decorative article using a spectrophotometer (Minolta, CM-2022), and the color difference before and after exposure to this environment was determined and evaluated according to the following four grades.
A: color difference ΔE < 3
B: 3 ≤colar difference ΔE < 4
C: 4 ≤ color difference ΔE < 5
D: 5 ≤ color difference ΔE

The light source for the spectrophotometer was a D₆₅ light source defined in JIS Z 8720, and measurements were taken at a viewing angle of 2°.

6. Chemical resistance evaluation

The chemical resistance of the decorative articles manufactured in each of the embodiments and comparisons described above was evaluated after an air exposure test as described below.

Artificial perspiration was placed in a dessicator and left at 40°C for 18 hours. The decorative articles were then placed in the dessicator and left at 40°C. The decorative articles were placed so that they were not immersed in the artificial perspiration. After 36 hours the decorative articles were removed from the dessicator, the color tone of the side on which the coating was formed was measured using a spectrophotometer (Minolta, CM-2022), and the color difference before and after exposure to this exposure test was determined and evaluated according to the following four grades.
A: color difference ΔE < 3
B: 3 ≤ color difference ΔE < 4
C: 4 ≤ color difference ΔE < 5
D: 5 ≤ color difference ΔE

The light source for the spectrophotometer was a D₆₅ light source defined in JIS Z 8720, and measurements were taken at a viewing angle of 2°.

7. Coating adhesion evaluation

The adhesion of the coatings (first coating, second coating, base layer) of the decorative articles manufactured in each of the embodiments and comparisons described above was evaluated using the test described below.

Each decorative article was subj ected to the following heat cycle test.

Each decorative article was left at rest for 1 hour at 20°C, then 2 hours at 65°C, then 1 hour at 20°C, and then 2 hours at -15°C. The ambient temperature was then returned to 20°C to complete one cycle (6 hours). Each sample was subjected to 4 cycles (24 hours).

The appearance of each sample was then visually inspected and graded according to the four levels described below.
A: no lifting or separation of the coating
B: substantially no lifting of the coating observed
C: obvious lifting of the coating observed
D: obvious cracking or separation of the coating observed

8. Scratch resistance

The scratch resistance of the decorative articles manufactured in each of the embodiments and comparisons described above was evaluated as described below.

Using a Suga abrasion tester (NUS-ISO-1, manufactured by Suga Test Instruments) with a 200 gf load, the side of the decorative article on which the coating was formed (the opposite side as the side on which the surface of the base member is exposed) was rubbed with a total 300 double strokes (DS). The appearance of the surface was then visually evaluated and graded according to the following four levels. Note that the test was conducted using a lapping film (aluminum oxide with 30 µm grain size) manufactured by Sumitomo 3M Ltd.
A: no surface scratching observed
B: substantially no surface scratching observed
C: slight surface scratching observed
D: conspicuous surface scratching or separation of the coating observed

9. Dent resistance

The dent resistance of the decorative articles manufactured in each of the embodiments and comparisons described above was evaluated as described below.

A stainless steel ball (1.5 cm diameter) was dropped from a height of 50 cm onto the side of the decorative article on which the coating was formed, and the size of any dent in the surface of the dart (the diameter of the dent) was measured and graded according to the following four levels.
A: dent diameter < 1 mm, or no dent observed
B : 1 mm ≤ dent diameter < 2 mm
C: 2 mm ≤ dent diameter < 3 mm
D: 3 mm ≤ dent diameter

The results of these tests are shown together with the Vickers hardness in Table 4, Table 5, and Table 6. Note that Vickers hardness Hv was measured at the surface of the decorative article (the surface on the side where the coating was formed) using a 10 gf test load.

**Table 4**

| | Vickers hardness | Appearance | | | Long-term stability | Oxidation resistance | Chemical resistance | Coating adhesion | Scratch resistance | Dent resistance |
|---|---|---|---|---|---|---|---|---|---|---|
| | | Visual | Chromoscope | | | | | | | |
| | | | a*b* | L* | | | | | | |
| Embodiment 1 | 600 | A | A | A | A | A | A | A | A | A |
| Embodiment 2 | 650 | A | A | A | A | A | A | A | A | A |
| Embodiment 3 | 950 | A | k | A | A | A | A | B | A | A |
| Embodiment 4A | 600 | B | B | A | A | A | A | B | B | A |
| Embodiment 5 | 600 | B | A | A | A | A | A | B | A | A |
| Embodiment 6 | 650 | B | A | B | B | B | B | A | B | A |
| Embodiment 7 | 500 | B | A | A | A | B | B | B | A | B |
| Embodiment 8 | 550 | B | B | A | A | A | A | B | A | B |
| Embodiment 9 | 650 | A | A | A | A | A | A | A | A | A |
| Embodiment 10 | 650 | A | A | A | A | A | A | A | A | A |
| Embodiment 11 | 600 | B | B | A | A | A | A | A | A | A |
| Embodiment 12 | 600 | A | A | A | A | A | A | A | A | A |
| Embodiment 13 | 800 | A | A | A | A | A | A | B | A | A |
| Embodiment 14 | 850 | B | A | B | A | B | B | B | A | A |
| Embodiment: 15 | 600 | A | A | A | A | A | B | B | A | A |
| Embodiment 16 | 600 | B | B | A | A | A | B | B | A | A |
| Embodiment 17 | 600 | B | A | B | A | B | B | A | A | A |
| Embodiment 18 | 650 | A | A | A | A | A | A | A | A | A |
| Embodiment 19 | 610 | A | A | A | A | A | A | A | A | A |
| Embodiment 20 | 650 | B | B | A | A | A | A | B | A | A |

**Table 5**

| | Vickers hardness | Appearance | | | Long-term stability | Oxidation resistance | Chemical resistance | Coating adhesion | Scratch resistance | Dent resistance |
|---|---|---|---|---|---|---|---|---|---|---|
| | | Visual | Chromoscope | | | | | | | |
| | | | a*b* | L* | | | | | | |
| Embodiment 21 | 600 | A | A | A | A | A | A | A | A | A |
| Embodiment 22 | 600 | A | A | A | A | A | A | A | A | A |
| Embodiment 23 | 650 | B | A | A | A | A | A | B | A | A |
| Embodiment 24 | 650 | B | B | B | A | A | A | B | A | A |
| Embodiment 25 | 600 | B | B | B | A | A | A | B | A | A |
| Embodiment 26 | 500 | B | A | B | A | A | B | A | A | B |
| Embodiment 27 | 650 | A | A | A | A | A | A | A | A | A |
| Embodiment 23 | 600 | A | A | A | A | A | A | A | A | A |
| Embodiment 29 | 650 | B | A | A | A | A | A | A | A | A |
| Embodiment 30 | 600 | A | A | A | A | A | A | A | A | A |
| Embodiment 31 | 750 | A | A | A | A | A | A | B | A | A |
| Embodiment 32 | 650 | B | A | B | A | B | B | A | A | A |
| Embodiment 33 | 600 | B | B | A | A | A | A | B | A | A |
| Embodiment 34 | 600 | A | A | A | A | A | A | A | A | A |
| Embodiment 35 | 500 | B | A | B | A | A | A | B | A | B |
| Embodiment 36 | 600 | A | A | A | A | A | A | A | A | A |
| Embodiment 37 | 600 | A | A | A | A | A | A | A | A | A |
| Embodiment 38 | 700 | A | A | A | A | A | A | A | A | A |
| Embodiment 39 | 650 | A | A | A | A | A | B | B | A | A |

**Table 6**

| | Vickers hardness | Appearance | | | Long-term stability | Oxidation resistance | Chemical resistance | Coating adhesion | Scratch resistance | Dent resistance |
|---|---|---|---|---|---|---|---|---|---|---|
| | | Visual | Chromoscope | | | | | | | |
| | | | a*b* | L* | | | | | | |
| Comparison 1 | 180 | B | B | B | D | B | B | D | D | D |
| Comparison 2 | 600 | E | E | E | A | A | A | A | A | A |
| Comparison 3 | 600 | D | D | D | A | A | A | C | A | A |
| Comparison 4 | 500 | D | D | D | B | A | A | A | C | B |
| Comparison 5 | 600 | C | C | C | C | C | D | B | A | A |
| Comparison 6 | 500 | E | E | B | C | C | D | B | C | B |
| Comparison 7 | 600 | D | D | B | B | B | B | C | A | A |
| Comparison 8 | 600 | C | B | B | B | C | C | D | A | A |
| Comparison 9 | 600 | E | D | A | A | A | A | A | A | A |
| Comparison 10 | 600 | C | B | A | B | B | B | D | A | A |
| Comparison 11 | 600 | E | E | A | A | A | A | A | A | A |
| Comparison 12 | 600 | D | C | D | C | D | D | D | A | A |
| Comparison 13 | 500 | C | B | D | C | D | D | D | D | B |
| Comparison 14 | 500 | C | B | A | B | B | C | C | C | B |
| Comparison 15 | 600 | C | B | B | B | B | C | C | B | A |
| Comparison 16 | 450 | E | E | C | C | C | D | D | D | C |
| Comparison 17 | 600 | C | B | B | C | D | D | D | A | A |
| Comparison 18 | 600 | B | B | A | B | C | D | C | A | A |
| Comparison 19 | 400 | A | A | B | D | D | D | D | D | C |
| Comparison 20 | 190 | A | A | B | D | D | D | D | D | D |

As shown in Table 4, Table 5, and Table 6, the decorative article according to the invention exhibits an outstanding appearance, and more particularly a beautiful appearance with a light gold color.

The decorative article according to the invention also features excellent long-term stability, oxidation resistance, chemical resistance, and coating adhesion.

The decorative article according to the invention also has high hardness and excellent resistance to scratching and denting.

As a result, a decorative article according to the invention can retain an outstanding appearance for a long time.

The decorative article of the invention also has an outstanding surface texture with no surface roughness.

Satisfactory results were not obtained with the comparison samples, however.

In addition, in the samples in which the first coating is made of TiN (TiCN) with a predetermined amount of C, the coating (first coating and second coating) can be suitably removed using an aqueous solution of containing 15 vol% nitric acid (HNO₃) and 15 vol% sulfuric acid (H₂SO₄). The coating (first coating and second coating) can also be suitably reapplied after being removed to restore the outstanding appearance of the decorative article.

A wristwatch as shown in FIG. 5 was also assembled using the decorative articles described in the foregoing embodiments and comparison samples. When the wristwatch was evaluated using the tests described above, the same results were achieved.

Although the present invention has been described in connection with the preferred embodiments thereof with reference to the accompanying drawings, it is to be noted that various changes and modifications will be apparent to those skilled in the art. Such changes and modifications are to be understood as included within the scope of the present invention as defined by the appended claims, unless they depart therefrom.

## Claims

1. A method of manufacturing a decorative article (1), comprising:
a first coating formation step of forming a first coating (3) of primarily TiN on a base member (2); and
a second coating formation step of forming a second coating (4) on the first coating (3) by means of a dry plating method using an Au-Pd-Ag-In alloy of primarily Au and containing 6.0 - 9.0 wt% Pd, 6.0 - 8.0 wt% Ag, and 7.0 - 9.0 wt% In as a target.

2. The method of manufacturing a decorative article (1) described in claim 1, wherein the second coating (4) is formed by sputtering.

3. The method of manufacturing a decorative (1) article described in claim 1 or 2, further comprising:
a base layer formation step of forming a base layer (5) of at least one layer on the base member (2) before the first coating formation step.

4. The method of manufacturing a decorative article (1) described in claim 3, wherein a layer of primarily Ti is formed as the base layer (5).

5. A decorative article manufactured by the method described in any one of claims 1 to 4.

6. A decorative article (1) comprising:
a base member (2);
a first coating (3) of primarily TiN; and
a second coating (4) that is disposed on the opposite surface of the first coating (3) as the surface facing the base member (2), and is formed from an Au-Pd-Ag-In alloy of primarily An and containing 6.0 - 9.0 wt% Pd, 6.0 - 8.0 wt% Ag, and 7.0 - 9.0 wt% In.

7. The decorative article (1) or method of its manufacture described in any one of claims 1 to 6, wherein:
the base member (2) is made of primarily Ti and/or stainless steel at least in the surface region.

8. The decorative article (1) or method of its manufacture described in any one of claims 1 to 7, wherein:
the N content in the first coating (3) is 2 - 29 wt%.

9. The decorative article (1) or method of its manufacture described in any one of claims 1 to 8, wherein:
the average thickness of the first coating (3) is 0.1 - 5.0 µm,

10. The decorative article (1) or method of its manufacture described in any one of claims 1 to 9, wherein:
the average thickness of the second coating (4) is 0.02 - 2.0 µm,

11. The decorative article (1) or method of its manufacture described in any one of claims 1 to 10, wherein:
the color tone of the surface on the side to which the second coating (4) is disposed has an a* in the range 0.7 - 2.9 and a b* in the range 12.3 - 16.9 when expressed in the L*a*b* chromaticity diagram defined in JIS Z 8729.

12. The decorative article (1) or method of its manufacture described in any one of claims 1 to 11, wherein: the color tone of the surface on the side to which the second coating (4) is disposed has an L* in the range 84.2 - 88.4 when expressed in the L*a*b* chromaticity diagram defined in JIS Z 8729.

13. The decorative article described in any one of claims 5 to 12, wherein the decorative article is an external part of a timepiece.

14. A timepiece comprising the decorative article described in any one of claims 5 to 13.

15. Use of the decorative article described in any one of claims 5 to 13 as an external part of a timepiece.
